# EUROPÄISCHE PATENTANMELDUNG

(11) **EP 3 840 549 A1**
(43) Veröffentlichungstag der Anmeldung: **23.06.2021**
(21) Anmeldenummer: 19218479.4
(22) Anmeldetag: 20.12.2019
(51) Int. Cl.: H05K 3/28, H05K 3/32

(54) **LEITERPLATTE MIT EINEM OBERFLÄCHENMONTIERTEN ELEKTRONISCHEN BAUTEIL UND VERFAHREN ZU DEREN HERSTELLUNG**

(71) Anmelder: ZKW Group GmbH, 3250 Wieselburg (AT)
(72) Erfinder: Kieslinger, Dietmar, 2604 Theresienfeld (AT); Führinger, Roman, 2803 Schwarzenbach (AT)
(74) Vertreter: Patentanwaltskanzlei Matschnig & Forsthuber OG

(57) **Zusammenfassung**

Die Erfindung betrifft eine Leiterplatte (10) mit zumindest einem an einer Außenseite (11) der Leiterplatte (10) montierten elektronischen Bauteil (20). Zwischen dem zumindest einen elektronischen Bauteil (20) und der dem Bauteil (20) zugeordneten Außenseite (11) der Leiterplatte (10) ist eine Kunststofffolie (30) mit einer Foliendicke (31) sowie mit mehreren Ausnehmungen (32) angeordnet, wobei die Kunststofffolie (30) an der Außenseite (11) der Leiterplatte (10) befestigt ist und wobei die Ausnehmungen (32) in der Kunststofffolie (30) mit Leitkleber (50) zumindest teilweise befüllt sind und diese Ausnehmungen (32) an der Setzposition (29) des Bauteils (x) so positioniert sind, dass mit dem Leitkleber (50) innerhalb einer Ausnehmung (32) ein Leiterbahnabschnitt (12) an der Außenseite (11) der Leiterplatte (10) mit einem Kontaktpad (25) an der Unterseite (21) des zumindest einen Bauteils (20) leitend verbunden ist. Weiters wird im Rahmen der Erfindung ein Herstellungsverfahren für eine solche Leiterplatte (10) angegeben.

## Beschreibung

Die Erfindung betrifft eine Leiterplatte mit zumindest einem an einer Außenseite der Leiterplatte montierten elektronischen Bauteil. Weiters werden im Rahmen der Erfindung Verfahren zur Herstellung einer solchen Leiterplatte angegeben.

Eine Leiterplatte (Leiterkarte, Platine, Schaltungsträger oder gedruckte Schaltung; englisch: printed circuit board, kurz: PCB) ist ein Träger für elektronische Bauteile. Sie dient der mechanischen Befestigung und elektrischen Verbindung solcher Bauteile. Nahezu jedes elektronische Gerät enthält eine oder mehrere Leiterplatten.

Leiterplatten bestehen aus elektrisch isolierendem Material mit daran haftenden, leitenden Verbindungen (Leiterbahnen). Als isolierendes Material wird üblicherweise faserverstärkter Kunststoff eingesetzt. Die Leiterbahnen werden zumeist aus einer dünnen Schicht Kupfer geätzt. Die elektronischen Bauteile werden auf Lötflächen (Kontaktpads) oder in Lötaugen gelötet. So werden sie in Einbaulage an diesen Kontaktpads gleichzeitig mechanisch gehalten und elektrisch mit den entsprechenden Leiterbahnen verbunden.

Unter dem Begriff eines "Substrats" kann in diesem Zusammenhang ein Träger für elektrische Verbindungen bzw. ein Komponententräger ähnlich einer PCB-Leiterplatte verstanden werden, wobei ein solches Substrat jedoch eine wesentlich höhere Dichte von lateralen (Leiterbahnen) und/oder vertikalen (Bohrungen) Verbindungsstellen aufweisen kann, wie sie beispielsweise zur Herstellung von elektrischen und mechanischen Verbindungen von gehäusten oder ungehäusten elektronischen Bauteilen und einer Leiterplatte eingesetzt werden. Insbesondere können auch kleinste Bauteile wie beispielsweise ein IC Chip auf einem Substrat angeordnet werden. Unter den Begriff "Substrat" fallen somit auch sogenannte "IC Substrate".

Im Weiteren wird der Begriff "Leiterplatte" synonym als Bezeichnung für eine Anschlussplatte für elektronische Komponenten in Form einer Leiterplatte oder eines Substrats bzw. eines IC-Substrats verstanden, wobei die Anschlussplatte üblicherweise eine Mehrzahl von Isolationsschichten und leitenden Schichten umfasst.

Unbedrahtete elektronische Bauteile, die direkt auf die Leiterbahnen einer Leiterplatte gelötet werden, und die als oberflächenmontierte Bauteile (englisch: surface mounted devices, kurz SMD) bezeichnet werden, ermöglichen es, die Packungsdichte von Leiterplatten zu erhöhen. Solche oberflächenmontierten Bauteile (SMD) können vorteilhaft auf beiden Außenseiten einer Leiterplatte platziert werden.

Ein wesentlicher Vorteil von SMD-Bauteilen ist die einfache Handhabung in automatischen Bestückungssystemen. Nachteilig ist dabei allerdings, dass automatische Bestückungsmaschinen die elektronischen Bauteile mit einer gewissen Bestückungskraft auf den dafür vorgesehenen Auflagepunkten an der Außenseite der Leiterplatte aufsetzen, was insbesondere beim Einsatz von Leitkleber für die Montage von empfindlichen Bauteilen zu einer Beschädigung der Kontaktpads an deren Unterseite und/oder zum zu starken Zusammendrücken des Leitkleberdepots unterhalb der Kontaktpads führen kann. Leitkleber, der seitlich über die eigentliche Klebestelle hinausquillt, kann jedoch zu elektrischen Kurzschlüssen unterhalb der montierten Bauteile führen.

Aus dem Stand der Technik ist weiters bekannt, spezielle Leitkleber beim Bestücken einzusetzen, welche Feststoffpartikel im Mikrometer- und/oder Nanometer-Maßstab beispielsweise in Form von Silber- oder Kupferpartikeln enthalten.

Beim Einsatz von Lotpaste anstelle von Leitkleber kann durch eine entsprechende Auswahl der Partikelgröße bzw. der Sieblinie von in der Lotpaste befindlichen Lotkugeln definiert werden, wie weit sich ein solches Lotpastendepot zusammendrücken lässt. Damit kann durch entsprechende Auswahl einer bestimmten Lotpaste die Spaltdicke der Lotpaste bestimmt werden.

Im Gegensatz dazu leistet ein Leitkleber jedoch nur einen sehr geringen Widerstand gegen ein Zusammendrücken des Leitklebers im Klebespalt zwischen der Leiterplatte und den Kontaktpads des elektronischen Bauteils, weshalb beim Einsatz von Leitkleber der Klebespalt daher beim Bestückungsvorgang meist sehr dünn wird. Die typischerweise angestrebte Klebespaltdicke von etwa 20 µm bis 100 µm wird beim Bestückungsvorgang unter Einsatz von Leitkleber beispielsweise auf eine Dicke von 0 µm bis 10 µm reduziert. Der Leitkleber wird also meist seitlich über die eigentliche Klebestelle an der Außenseite der Leiterplatte hinausgedrückt, wodurch es zu unerwünschten Kurzschlüssen an der Unterseite des montierten elektronischen Bauteils kommen kann. Weiters kann es aufgrund der Kombination aus einem sehr dünnen bzw. zu dünnen Klebespalt einerseits und unterschiedlichen thermischen Ausdehnungskoeffizienten der Leiterplatte im Vergleich zum elektronischen Bauteil andererseits zu Ausfällen bei thermischer Belastung infolge von unerwünschter Rissbildung der Klebestelle kommen.

Überdies zeigt sich, dass elektrisch leitfähige Kleber, die solche Metallpartikel enthalten, aufgrund von unerwünschten Korrosionseinflüssen im Laufe der Zeit an Leitfähigkeit verlieren können. Es ist daher erforderlich, derartige Klebestellen entsprechend gegenüber Umwelteinflüssen wie gasförmigen Schadstoffen - beispielsweise Ozon oder Schwefelwasserstoff - sowie gegenüber Feuchtigkeit abzuschirmen, was aufwendig ist.

Zusammengefasst ist auch der Einsatz von Leitklebern mit Metallpartikeln aufwendig, da die Leitkleber selbst teuer sind und durch die Metallpartikel die mechanischen und/oder elektrischen Eigenschaften der Klebestellen entsprechend verändert werden.

Die Verwendung von herkömmlichen Silberleitklebern in Kombination mit gängigen Bestückungsautomaten führt aufgrund der meist zu hohen Bestückungskraft des Bestückers dazu, dass der Klebespalt des Leitklebers zu stark seitlich verläuft und es daher unterhalb der elektronischen Bauteile zu unerwünschten Kurzschlüssen kommen kann.

Die Zuordnung von Begriffen hinsichtlich ihres Ortes oder ihrer Orientierung, wie beispielsweise "horizontal", "vertikal", "in horizontaler Richtung", "in vertikaler Richtung", "oben", "unten", "vorne", "darunter", "darüber" etc. werden in der folgenden Beschreibung lediglich zur Vereinfachung gewählt und beziehen sich möglicherweise auf die Darstellung in den Zeichnungen, nicht jedoch notwendigerweise auf eine Gebrauchs- oder Einbaulage der besprochenen Leiterplatten und/oder elektronischen Bauteile.

Die vorliegende Erfindung stellt sich somit die Aufgabe, für Leiterplatten mit oberflächenmontierten elektronischen Bauteilen der eingangs genannten Art die aus dem Stand der Technik bekannten Nachteile zu vermeiden und dazu eine verbesserte Leiterplatte anzugeben, bei der auch empfindliche elektronische Bauteile unter Einsatz von Leitkleber mit einem herkömmlichen Bestücker bestückt werden können, ohne dass es beim Bestücken zu unerwünschten Kurzschlüssen der elektronischen Bauteile und/oder zu Rissbildungen in den Klebestellen kommt.

Weiters ist es eine der Aufgaben der vorliegenden Erfindung, ein geeignetes Verfahren zur Herstellung einer solchen Leiterplatte bereitzustellen, welches die geschilderten Nachteile des Stands der Technik vermeidet.

Diese Aufgabe wird bei einer Leiterplatte gemäß dem Oberbegriff des Anspruchs 1 mit den Merkmalen des kennzeichnenden Teiles des Anspruchs 1 gelöst. Die Unteransprüche betreffen mögliche weitere besonders vorteilhafte Ausgestaltungen der Erfindung.

Erfindungsgemäß ist bei einer Leiterplatte mit zumindest einem an einer Außenseite der Leiterplatte montierten elektronischen Bauteil zwischen dem zumindest einen elektronischen Bauteil und der dem Bauteil zugeordneten Außenseite der Leiterplatte eine Kunststofffolie mit einer Foliendicke sowie mit mehreren Ausnehmungen angeordnet, wobei die Kunststofffolie an der Außenseite der Leiterplatte befestigt ist und wobei die Ausnehmungen in der Kunststofffolie mit Leitkleber zumindest teilweise befüllt sind und diese Ausnehmungen an der Setzposition des Bauteils so positioniert sind, dass mit dem Leitkleber innerhalb einer Ausnehmung ein Leiterbahnabschnitt an der Außenseite der Leiterplatte mit einem Kontaktpad an der Unterseite des zumindest einen Bauteils leitend verbunden ist.

Vorteilhaft wirkt die Kunststofffolie als Abstandhalter beim Bestücken und definiert je nach ausgewählter Foliendicke einerseits den Abstand zwischen der Unterseite des elektronischen Bauteils und der entsprechenden Außenseite der Leiterplatte und andererseits die Höhe der Leitkleberschicht innerhalb der Ausnehmungen, somit also die Höhe des Klebespalts beim Bestücken. Weiters ist von Vorteil, dass die Kunststofffolie als Isolator wirkt und somit zusätzlich Schutz vor unerwünschten Kontaktfehlern und Kurzschlüssen zwischen dem oberflächenmontierten Bauteil und der Leiterplatte bietet. Der verwendete Leitkleber, beispielsweise ein Silberleitkleber, wird innerhalb der Ausnehmungen der Kunststofffolie aufgebracht. Die Ausnehmungen dienen somit als seitliche Begrenzungen vergleichbar mit Schablonen für den Leitkleber, der vorteilhaft nicht seitlich verlaufen kann, sondern innerhalb der Ausnehmungen die Kontaktierung der Kontaktpads mit den entsprechenden Leiterbahnabschnitten der Leiterplatte gewährleistet.

Selbstredend können im Rahmen der Erfindung ein oder mehrere elektronische Bauteile auf einer Außenseite oder auch auf beiden Außenseiten einer Leiterplatte oberflächenmontiert sein. Im Fall einer beidseitigen Oberflächenmontage von Bauteilen werden dann auf beiden Außenseiten der Leiterplatte entsprechende Kunststofffolien als Abstandhalter angeordnet.

Vorteilhaft kann bei einer Leiterplatte gemäß der Erfindung das zumindest eine elektronische Bauteil zumindest abschnittsweise mit seiner Unterseite auf der Außenseite der Kunststofffolie aufliegen. Für den Fall, dass bei einem automatisierten Bestückungsvorgang vom Bestücker ein elektronisches Bauteil mit einer größeren Bestückungskraft auf die Außenfläche der Leiterplatte aufgesetzt wird, so hilft die Kunststofffolie als Abstandhalter dabei, die Druckkraft bzw. Bestückungskraft zu reduzieren, indem das Bauteil flächig zumindest mit Abschnitten seiner Unterseite auf der Kunststofffolie aufliegt. Die Kontaktpads des Bauteils befinden sich in gesetzter Position innerhalb der dafür vorgesehenen Ausnehmungen in der Kunststofffolie. Dies bietet den Vorteil, dass mechanische Beschädigungen des Bauteils bzw. von dessen Kontaktpads infolge der Bestückungskraft vermieden werden können.

Zweckmäßig kann bei einer erfindungsgemäßen Leiterplatte eine Füllhöhe des Leitklebers innerhalb der Ausnehmungen der Kunststofffolie kleiner oder gleich der Foliendicke der Kunststofffolie sein. Die Füllhöhe des Leitklebers innerhalb der Ausnehmungen der Kunststofffolie kann an die Bauart der zu montierenden elektronischen Bauteile angepasst werden.

Bei elektronischen Bauteilen mit Kontaktpads, die im Wesentlichen plan mit der Unterseite des entsprechenden Bauteils abschließen, wird die Füllhöhe des Leitklebers innerhalb der Ausnehmungen zweckmäßigerweise so gewählt werden, dass diese gleich der Foliendicke der Kunststofffolie ist oder geringfügig größer als diese und somit die Füllhöhe des Leitklebers etwas über die Foliendicke hinausragt. Solche Bauteile werden als untere Anschlusskomponenten (englisch: bottom termination components, kurz: BTC) bezeichnet und sind auch unter anderen Namen in der Elektronikindustrie wie QFN (Quad Flat No Leads Package) oder LGA (Land Grid Array) bekannt. Das entscheidende Merkmal solcher Bauteile ist, dass alle Kontaktanschlüsse im Wesentlichen flach auf der Unterseite des Bauteils liegen und sich nur auf Lötpaste bzw. Leitkleber verlassen, um die Verbindung von Bauteil zu Leiterplatte herzustellen. Meist werden auch elektronische Bauteile, deren Kontaktpads beispielsweise 20 µm oder 30 µm weit von der Unterseite des Bauteils nach unten vorstehen, als BTC's bezeichnet.

Bei elektronischen Bauteilen mit Kontaktpads, die von der Unterseite des Bauteils nach unten vorragen bzw. abstehen, kann die Füllhöhe des Leitklebers innerhalb der Ausnehmungen entsprechend niedriger gewählt werden als der Foliendicke der Kunststofffolie entspricht, um dennoch einen fehlerfreien elektrischen Kontakt zwischen dem jeweiligen Kontaktpad und dem entsprechend dem Kontaktpad zugeordneten Leiterbahnabschnitt auf der Leiterplattenaußenseite zu gewährleisten. Durch den Einsatz der Kunststofffolie als Abstandhalter mit den entsprechenden Ausnehmungen zur Aufnahme von Leitkleber wird somit die Flexibilität bei der Bestückung deutlich erhöht und es können unterschiedliche Bauarten von elektronischen Bauteilen mit flachen Kontaktflächen (BTC's) ebenso wie Bauteile mit Kontaktpads, die an deren Unterseite abstehen, auf ein und derselben Leiterplatte montiert werden.

In einer bevorzugten Ausführung der Erfindung kann bei einer Leiterplatte jedem Kontaktpad des zumindest einen elektronischen Bauteils eine eigene Ausnehmung in der Kunststofffolie zugeordnet sein. Mit einer solchen 1:1-Zuordnung, wobei jedem Kontaktpad genau eine eigene Ausnehmung in der Kunststofffolie zugeordnet ist, können Kontaktfehler beim Bestücken der Bauteile besonders effizient vermieden werden.

In einer Weiterbildung der Erfindung kann bei einer Leiterplatte die Kunststofffolie an der Außenseite der Leiterplatte zumindest abschnittsweise mit einer Klebstoffschicht angeklebt sein.

Dies hat den Vorteil, dass die Kunststofffolie in ihrer exakten Einbaulage an der Leiterplattenaußenseite durch Kleben befestigt werden kann. Weiters bietet der Einsatz einer Klebstoffschicht zwischen der Kunststofffolie und der Leiterplattenaußenseite den Vorteil, dass die Kunststofffolie plan auf der Außenseite der Leiterplatte aufliegt und damit das Eindringen von Feuchtigkeit oder Staub zwischen der Kunststofffolie und der Leiterplatte vermieden werden kann.

Besonders vorteilhaft kann es in ersten Ausführungsvariante der Erfindung sein, wenn bei einer erfindungsgemäßen Leiterplatte die Kunststofffolie eine Erweichungstemperatur hat, die kleiner als die Härtungstemperatur des Leitklebers ist.

Um den Leitkleber auszuhärten und die montierten elektronischen Bauteile in ihrer exakten Setzposition an der Außenseite der Leiterplatte zu fixieren, ist eine Temperaturbehandlung der Leiterplatte nach dem Bestücken erforderlich. Wenn eine Kunststofffolie zum Einsatz kommt, deren Erweichungstemperatur kleiner ist als die Härtungstemperatur, so bietet dies den Vorteil, dass beim Erwärmen das Bauteil bei Überschreiten der Erweichungstemperatur der Kunststofffolie noch mechanisch ausgerichtet werden kann, bevor bei Erreichen der höheren Härtungstemperatur des Leitklebers dieser aushärtet und damit das Bauteil in seiner Setzposition fixiert ist. Wichtig ist dabei, dass in diesem bevorzugten Fall Kunststofffolien verwendet werden, deren Erweichungstemperatur zwar etwas unterhalb der Härtungstemperatur des Leitklebers liegt, die aber bei Erreichen der Härtungstemperatur des Leitklebers noch nicht schmelzen. Denn dann wäre ein exaktes Fixieren des Bauteils in seiner Setzposition an der Leiterplattenaußenseite nicht mehr gewährleistet. Allerdings ist in einem solchen Anwendungsfall möglicherweise zu beachten, dass die Kunststofffolie das Bauteil und die Klebestellen zwischen den Kontaktpads und den Leiterbahnabschnitten nicht hermetisch abdichten und umschließen, da eben die Kunststofffolie nicht vollständig aufschmelzen soll.

Zweckmäßig kann bei einer Leiterplatte die Kunststofffolie eine Erweichungstemperatur von 90° bis 120°C und der Leitkleber eine Härtungstemperatur von 100° bis 150°C aufweisen.

Beispielsweise können dazu sogenannte Polybutadien-basierte Polymere, die eine Erweichungstemperatur von etwa 100° bis 120°C aufweisen, zum Einsatz gelangen. Ebenso bietet sich beispielsweise der Einsatz von Polybutylensuccinat (PBS) als Folienmaterial an, da diese Kunststofffolie eine Erweichungstemperatur von rund 115°C aufweist und vorteilhaft einen großen Dauergebrauchstemperaturbereich von -40° bis rund 115°C aufweist. Übliche Silberleitkleber weisen Härtungstemperaturen von 100° bis 150°C auf.

In einer weiteren vorteilhaften Ausführungsvariante kann bei einer Leiterplatte die Kunststofffolie eine Erweichungstemperatur haben, die größer als die Härtungstemperatur des Leitklebers ist.

Diese Ausführungsvariante bietet den Vorteil, dass durch Anpassen eines geeigneten Heizprofils je nach verwendetem Kunststofffolienmaterial einerseits eine exakte Fixierung des Bauteils in seiner Setzposition, als auch andererseits ein anschließendes vollständiges Umschmelzen und Abdichten der bereits ausgehärteten Kontaktverbindungen mit dem aufgeschmolzenen Kunststoffmaterial sichergestellt werden kann. Wie vorhin bereits erwähnt, liegt die Härtungstemperatur gängiger Silberleitkleber bei etwa 100° bis 150°C. Kunststofffolien, die erst bei diesen Temperaturen zu erweichen beginnen, sind beispielsweise Polycarbonat (PC) mit einer Erweichungstemperatur von rund 148°C oder aber Polymethylmethacrylat (PMMA), das eine Glastemperatur von rund 105°C aufweist und erst jenseits von 100°C plastisch verformbar wird.

In einer Weiterbildung der Erfindung kann die Kunststofffolie eine Erweichungstemperatur von 140° bis 160°C und der Leitkleber eine Härtungstemperatur von 100° bis 150°C aufweisen.

Ein vollständiges Aufschmelzen tritt bei PMMA, dessen Schmelzpunkt beispielsweise bei 160°C liegt, erst bei Temperaturen ab 160°C auf. Durch Anpassen des Heizprofils beispielsweise als zweistufiges Heizprofil mit einer ersten Haltetemperatur etwa bei 125°C und einer anschließenden, zweiten Haltetemperatur bei 160°C kann somit sichergestellt werden, dass zuerst bei der niedrigeren Haltetemperatur die Kleberschichtdicke des Leitklebers fixiert wird und der Leitkleber ausgehärtet ist, bevor dann anschließend bei der zweiten, höheren Haltetemperatur die Kunststofffolie schmilzt und damit die Leitkleberkontaktverbindungen innerhalb der Ausnehmungen der Kunststofffolie umschmolzen und dabei möglichst hermetisch abgedichtet werden.

Die eingangs genannten erfindungsgemäßen Aufgaben werden auch mit einem Verfahren zur Herstellung einer Leiterplatte mit zumindest einem an einer Außenseite der Leiterplatte montierten elektronischen Bauteil gelöst, wobei das Verfahren eine Abfolge der folgenden Schritte umfasst:
- a- Bereitstellen einer Leiterplatte mit Leiterbahnen zur außenseitigen Montage zumindest eines elektronischen Bauteiles;
- b- Bereitstellen einer Kunststofffolie mit einer Foliendicke, wobei die Kunststofffolie zumindest abschnittsweise an einer Außenseite der Leiterplatte im Bereich des zu bestückenden elektronischen Bauteiles befestigbar ist;
- c- Herstellen von Ausnehmungen in der Kunststofffolie, wobei die Position der Ausnehmungen der Lage der Kontaktpads des zu bestückenden elektronischen Bauteiles in seiner Setzposition entsprechen und die Ausnehmungen jeweils komplementär sind mit einem Abschnitt einer Leiterbahn an der Außenseite der Leiterplatte;
- d- Befestigen der Kunststofffolie an derjenigen Außenseite der Leiterplatte, welche dem für die außenseitige Montage vorgesehenen zumindest einen elektronischen Bauteil zugeordnet ist, wobei die Ausnehmungen in der Kunststofffolie anhand der Setzpositionen der Kontaktpads des Bauteils sowie des Verlaufs der Leiterbahnen ausgerichtet werden;
- e- Aufbringen von Leitkleber in den Ausnehmungen der befestigten Kunststofffolie, wobei die Füllhöhe des Leitklebers innerhalb der Ausnehmungen kleiner oder gleich der Foliendicke gewählt wird;
- f- Bestücken eines elektronischen Bauteils, wobei das Bauteil mit seiner Unterseite in seiner Setzposition so auf der Kunststofffolie aufgedrückt wird, dass die Kontaktpads des Bauteils im Bereich der Ausnehmungen zu liegen kommen und mit dem Leitkleber kontaktiert werden, wobei das Bauteil an seiner Unterseite zumindest abschnittsweise auf der Kunststofffolie aufliegt.

Hinsichtlich der vorteilhaften Wirkungen des erfindungsgemäßen Herstellungsverfahrens wird auf die bereits zuvor genannten Vorteile der Leiterplattenprodukte verwiesen, die sinngemäß gleichlautend auch auf das Verfahren zutreffen.

Ein wesentlicher Vorteil der Erfindung besteht darin, dass eine Kunststofffolie auf die Leiterplatte aufgelegt wird, bevor der Leitkleber aufgetragen wird. In dieser Kunststofffolie sind die Kontaktpads freigestellt in Form von Ausnehmungen bzw. Öffnungen oder Fenster in der Kunststofffolie. Die Dicke der Folie soll dabei etwa dem gewünschten Klebespalt bei elektronischen Bauteilen mit flachen Kontaktflächen (BTC's) entsprechen.

In einer vorteilhaften Weiterbildung des Herstellungsverfahrens kann in Schritt -d- die Kunststofffolie mit einer Klebstoffschicht zumindest abschnittsweise an einer Außenseite der Leiterplatte angeklebt werden.

Dies hat den Vorteil, dass die Kunststofffolie in ihrer exakten Einbaulage an der Leiterplattenaußenseite durch Kleben befestigt wird. Weiters bietet der Einsatz einer Klebstoffschicht zwischen der Kunststofffolie und der Leiterplattenaußenseite den Vorteil, dass die Kunststofffolie plan auf der Außenseite der Leiterplatte aufliegt und damit das Eindringen von Feuchtigkeit oder Staub zwischen der Kunststofffolie und der Leiterplatte vermieden werden kann.

Zweckmäßig kann bei einem erfindungsgemäßen Herstellungsverfahren in Schritt -e- der Leitkleber mit einem Dispenser in die Ausnehmungen der Kunststofffolie eingebracht werden.

Vorteilhaft kann mit einem Dispenser eine 3D-Topologie der Kontaktflächen der entsprechenden elektronischen Bauteile umgesetzt werden. BTC-Bauteile mit Kontaktflächen, die im Wesentlichen plan sind mit der Unterseite dieser Bauteile, werden demnach zum sicheren Ankontaktieren Kleberdepots benötigen, bei denen die Füllhöhe des Leitkleber der Foliendicke der Kunststofffolie entspricht oder erforderlichenfalls sogar geringfügig über diese Foliendicke hinausgeht, ohne dass es dabei zu einem seitlichen Verrinnen des Leitklebers über die Konturen der Kunststoffausnehmungen hinaus kommt. Im letztgenannten Ausführungsfall entspricht die Füllhöhe des Leitklebers somit im Wesentlichen der Foliendicke der Kunststofffolie und kann erforderlichenfalls beispielsweise um bis zu 10% über die Foliendicke hinausgehen.

Bei Bauteilen mit Kontaktpads, die beispielsweise 10 µm von der Bauteilunterseite nach unten abstehen, wird die Füllhöhe des Leitklebers entsprechend etwas unterhalb der Foliendicke der Kunststofffolie eingestellt werden können, um dennoch ein sicheres Ankontaktieren der Kontaktpads zu gewährleisten. Mit einem Dispenser können also vorteilhaft die Volumina an jeweils erforderlichem Leitkleber individuell eingestellt werden. Dies hat einerseits den Vorteil, dass eine Überdosierung an Leitkleber vermieden werden kann und der Leitkleber beim Setzen des Bauteils nicht über die Ausnehmungen nach außen bzw. oben tritt und es zu unerwünschten Kurzschlüssen an der Unterseite der oberflächenmontierten Bauteile kommt. Andererseits kann mit der exakten Dosierung der jeweils benötigten Leitkleberdepots beim Dispensen der Materialverbrauch an Leitkleber reduziert werden, was aus Kostengründen sowie aus Gründen der Nachhaltigkeit und Ressourcenschonung Vorteile bietet.

Alternativ dazu kann in einer Variante des erfindungsgemäßen Herstellungsverfahrens in Schritt -e- der Leitkleber durch einen Schablonendruckprozess in die Ausnehmungen der Kunststofffolie eingebracht werden, wobei die Ausnehmungen der Kunststofffolie als Schablonen dienen.

Vorteilhaft bei einem Schablonendruckprozess sind die kurzen Taktzeiten, die praktisch unabhängig von der Anzahl der zu kontaktierenden Kontaktpads sind. Allerdings kann beim Schablonendruckverfahren unter Umständen überschüssiger Leitkleber anfallen, der von der Oberseite der Kunststofffolie, die dabei als Schablone dient, abzureinigen ist und der als Abfall verworfen werden muss. Weiters ist ein solches Schablonenverfahren zum Aufbringen von Leitkleber in die entsprechenden Ausnehmungen der Kunststofffolie nur für Bauteile geeignet, deren Kontaktpads zumindest 5 µm über die untere Auflagefläche des jeweiligen Bauteiles abstehen bzw. nach unten ragen. Bei elektronischen Bauteilen mit flachen Kontaktflächen (BTC's) kann es beim Schablonendruckverfahren zu Kontaktdefekten kommen, da unter Umständen zu geringe Leitkleberdepots bereitgestellt werden. In solchen Fällen ist das Einbringen von Leitkleber in die Ausnehmungen mittels Dispenser zu bevorzugen.

Vorteilhaft kann beim erfindungsgemäßen Herstellungsverfahren in Schritt -b- eine Kunststofffolie mit einer Erweichungstemperatur bereitgestellt werden, die kleiner als die Härtungstemperatur des Leitklebers ist, wobei nach dem Bestücken (Schritt -f-) in einem anschließenden Wärmebehandlungsschritt -g- die bestückte Leiterplatte bis zur Härtungstemperatur des Leitklebers erwärmt wird, wobei nach Überschreiten der Erweichungstemperatur der Kunststofffolie gegebenenfalls die Setzposition des elektronischen Bauteils mechanisch ausgerichtet wird.

Wie bereits zuvor erwähnt, wird die Kunststofffolie nach dem Aufbringen des Leitklebers auf der Leiterplatte bzw. dem Schaltungsträger belassen. Die Bauteile werden auf den Leitkleber und die Kunststofffolie gesetzt.

Die Kunststofffolie weist in dieser Ausführungsvariante eine Erweichungstemperatur auf, die unter der Härtetemperatur des Leitklebers liegt. Wird die Baugruppe erwärmt, um den Kleber zu härten oder um Lötstellen, die sich auch auf die Baugruppe befinden, zu löten, so erweicht die Kunststofffolie, umfließt das Kleberdepot und den Bauteil und bildet so eine zusätzliche Passivierung der Klebestelle und Fixierung des Bauteils.

Alternativ dazu kann beim erfindungsgemäßen Herstellungsverfahren in Schritt -b- eine Kunststofffolie mit einer Erweichungstemperatur bereitgestellt werden, die größer als die Härtungstemperatur des Leitklebers ist, wobei nach dem Bestücken (gemäß Schritt -f-) in einem anschließenden Wärmebehandlungsschritt -g'- die bestückte Leiterplatte zuerst bis zur Härtungstemperatur des Leitklebers erwärmt wird, und nach dem Aushärten des Leitklebers die bestückte Leiterplatte anschließend bis zur Erweichungstemperatur der Kunststofffolie, gegebenenfalls bis zur Schmelztemperatur der Kunststofffolie, erhitzt wird.

Diese Ausführungsvariante bietet den Vorteil, dass durch Anpassen eines geeigneten Heizprofils je nach verwendetem Kunststofffolienmaterial einerseits eine exakte Fixierung des Bauteils in seiner Setzposition, als auch andererseits ein anschließendes vollständiges Umschmelzen und Abdichten der bereits ausgehärteten Kontaktverbindungen mit dem aufgeschmolzenen Kunststoffmaterial sichergestellt werden kann. Wie vorhin bereits erwähnt, liegt die Härtungstemperatur gängiger Silberleitkleber bei etwa 100° bis 150°C. Kunststofffolien, die erst bei diesen Temperaturen zu erweichen beginnen, sind beispielsweise Polycarbonat (PC) mit einer Erweichungstemperatur von rund 148°C oder aber Polymethylmethacrylat (PMMA), das eine Glastemperatur von rund 105°C aufweist und erst jenseits von 100°C plastisch verformbar wird.

Ein vollständiges Aufschmelzen tritt bei PMMA bei Temperaturen ab 160°C auf. Durch Anpassen des Heizprofils beispielsweise als zweistufiges Heizprofil mit einer ersten Haltetemperatur etwa bei 125°C und einer anschließenden, zweiten Haltetemperatur bei etwa 160°C kann somit sichergestellt werden, dass zuerst bei der niedrigeren Haltetemperatur die Kleberschichtdicke des Leitklebers fixiert und der Leitkleber ausgehärtet wird, bevor dann anschließend bei der zweiten, höheren Haltetemperatur die Kunststofffolie schmilzt und damit die Leitkleberkontaktverbindungen innerhalb der Ausnehmungen der Kunststofffolie umschmolzen und dabei möglichst hermetisch abgedichtet werden.

Weitere Einzelheiten, Merkmale und Vorteile der Erfindung ergeben sich aus der nachfolgenden Erläuterung eines in der Zeichnung schematisch dargestellten Ausführungsbeispiels. In den Zeichnungen zeigen:
- **Fig. 1A** und **Fig. 1B** jeweils in Schnittansichten von der Seite den aus dem Stand der Technik bekannten Bestückungsvorgang eines elektronischen Bauteils an der Außenseite einer Leiterplatte;
- **Fig. 2A** und **Fig. 2B** jeweils in Schnittansichten von der Seite den erfindungsgemäßen Bestückungsvorgang eines elektronischen Bauteils an der Außenseite einer Leiterplatte unter Einsatz einer Kunststofffolie als Abstandhalter;
- **Fig. 3** in einer isometrischen Ansicht schräg von oben ein Detail der in Fig. 2A dargestellten Leiterplatte mit einer an ihrer Außenseite befestigten Kunststofffolie direkt vor dem Bestücken mit einem hier nicht gezeigten elektronischen Bauteil.

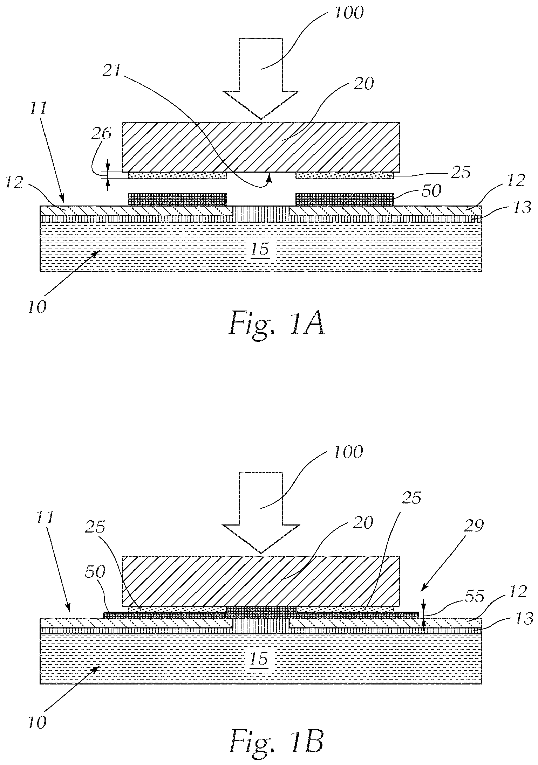

Die beiden **Figuren 1A** und **1B** betreffen jeweils einen aus dem Stand der Technik bekannten Bestückungsvorgang und zeigen jeweils im Schnitt ein Detail einer Leiterplatte 10, bei der an ihrer hier im Bild oben gelegenen Außenseite 11 der Leiterplatte 10 ein elektronisches Bauteil 20 mit einem Bestücker montiert wird. Die Leiterplatte 10 ist rein schematisch dargestellt und umfasst an ihrer Außenseite 11 Leiterbahnen 12, die auf einer darunter liegenden Isolationsschicht 13 aufgebracht sind. Unter der Isolationsschicht 13 ist schematisch ein Substrat 15 dargestellt, wobei je nach Anwendungsfall das Substrat 15 beispielsweise eine Mehrzahl einer Abfolge von leitenden und nichtleitenden, isolierenden Lagen aufweisen kann. Das ebenfalls rein schematisch dargestellte elektronische Bauteil 20 weist an seiner Unterseite 21 mehrere Kontaktpads 25 auf, die hier mit einer Höhe 26 von der Unterseite 21 des Bauteils 20 nach unten abstehen.

Fig. 1A zeigt den Bestückungsvorgang kurz vor dem Aufsetzen des elektronischen Bauteils 20 auf seiner Setzposition 29 an der Außenseite 11 der Leiterplatte 10.

Fig. 1B zeigt den Bestückungsvorgang mit bereits aufgesetztem elektronischen Bauteil 20. Wie in Fig 1A dargestellt, sind an der Oberseite bzw. Außenseite 11 der Leiterplatte 10 an den entsprechenden Setzpositionen 29 des elektronischen Bauteils 20 bzw. an den Setzpositionen 29 seiner Kontaktpads 25 jeweils Abschnitte mit Leitkleber 50 mit einer gewissen Schichtdicke aufgetragen.

Beim Bestücken beispielsweise mit einem automatischen Bestücker wird das elektronische Bauteil 20 mit einer gewissen Bestückungskraft 100, die als Pfeil 100 symbolisiert ist, mit seinen Kontaktpads 25 in der jeweiligen Setzposition 29 auf die Abschnitte mit Leitkleber 50 aufgedrückt. Mittels Leitkleber 50 werden leitende Kontakte zwischen den entsprechenden Kontaktpads 25 des elektronischen Bauteils 20 und den entsprechenden Leiterbahnen 12 der Leiterplatte 10 hergestellt.

Dabei kann es allerdings bei Aufbringen einer zu hohen Bestückungskraft 100 dazu kommen, dass der Leitkleber 50 seitlich unter den Kontaktpads 25 herausgequetscht wird und sich im Spalt zwischen der Unterseite 21 des Bauteils 20 und der Außenseite 11 der Leiterplatte 10 so verteilt, dass es zu unerwünschten Kurzschlussbildungen kommt. Dies ist schematisch in Fig. 1B dargestellt. Außerdem kann die Schichtdicke des Leitklebers 50, also die Klebespaltdicke 55 des Leitklebers, im verklebten Zustand zu dünn werden, um einen sicheren Kontakt zu gewährleisten. Weiters können die Kontaktpads 25 beim Bestücken beschädigt werden, wenn eine zu hohe Bestückungskraft 100 angewendet wird.

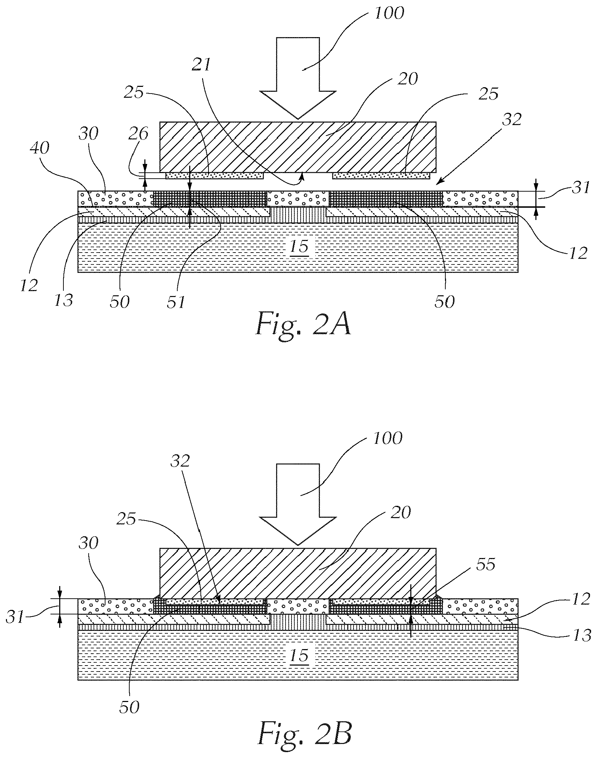

Die Figuren **2A** und **2B** zeigen jeweils in Schnittansichten von der Seite den erfindungsgemäßen Bestückungsvorgang eines elektronischen Bauteils 20 an der Außenseite 11 einer Leiterplatte 10 unter Einsatz einer Kunststofffolie 30 als Abstandhalter. Wie auch zuvor in der Figurenbeschreibung der aus dem Stand der Technik bekannten Figuren 1A und 1B wird auch in den Figuren 2A und 2B die Leiterplatte 10 rein schematisch dargestellt und umfasst an ihrer Außenseite 11 Leiterbahnen 12, die auf einer darunter liegenden Isolationsschicht 13 aufgebracht sind. Unter der Isolationsschicht 13 ist schematisch ein Substrat 15 dargestellt, wobei je nach Anwendungsfall das Substrat 15 beispielsweise eine Mehrzahl einer Abfolge von leitenden und nichtleitenden, isolierenden Lagen aufweisen kann.

Als Isolationsschicht 13 bzw. als elektrisch isolierendes Basismaterial des Trägers für elektrische Verbindungen können verstärkte oder unverstärkte Harze wie zum Beispiel Epoxidharz (zum Beispiel FR-4, FR-5), Teflon, Polyamid, oder Polyimid, Cyanatester und/oder Bismaleimid-Triazin Harz verwendet werden, alternativ oder ergänzend auch Gläser und glasartige oder verstärkende Trägermaterialien (zum Beispiel Multilayer Glas), sowie Keramiken oder Metalloxide.

Das ebenfalls rein schematisch dargestellte elektronische Bauteil 20 weist an seiner Unterseite 21 mehrere Kontaktpads 25 auf, die hier mit einer Höhe 26 von der Unterseite 21 des Bauteils 20 nach unten abstehen. Als elektronisches Bauteil 20 können beispielsweise jede aktive elektronische Komponente (wie zum Beispiel ein elektronischer Chip, insbesondere ein Halbleiterchip) oder jede beliebige passive elektronische Komponente (wie zum Beispiel ein Kondensator, ein Widerstand, eine Induktivität oder ein magnetisches Element wie beispielsweise ein Ferritkern) eingesetzt werden. Beispiele solcher elektronischer Bauteile können ein Datenspeicher wie zum Beispiel ein DRAM (oder jeder andere beliebige Speicher), ein Filter (der zum Beispiel als ein Hochpassfilter, ein Tiefpassfilter oder ein Bandpassfilter konfiguriert sein kann, und der zum Beispiel zum Frequenzfiltern dienen kann), ein integrierter Schaltkreis (wie zum Beispiel ein Logik IC), eine Signalverarbeitungskomponente (wie zum Beispiel ein Mikroprozessor), eine Leistungsmanagementkomponente, ein optisch-elektrisches Schnittstellenelement (zum Beispiel ein optoelektronisches Bauelement), ein Spannungswandler (wie zum Beispiel ein DC/DC Konverter oder ein AC/DC Konverter), ein elektromechanischer Wandler (z.B. ein PZT (Blei-Zirkonat-Titanat) Sensor und/oder Aktor), eine Sende- und/oder Empfangseinheit für elektromagnetische Wellen (z. B. ein RFID-Chip oder Transponder), eine kryptografische Komponente, eine Kapazität, eine Induktivität, ein Schalter (zum Beispiel ein Transistor-basierter Schalter) und eine Kombination von diesen und anderen funktionalen elektronischen Bauteilen sein. Ein solcher elektronischer Bauteil kann auch ein mikroelektromechanisches System (MEMS), eine Batterie, eine Kamera oder eine Antenne sein oder diese aufweisen.

Fig. 2A zeigt den Bestückungsvorgang kurz vor dem Aufsetzen des elektronischen Bauteils 20 auf seiner Setzposition 29 an der Außenseite 11 der Leiterplatte 10.

Fig. 2B zeigt den Bestückungsvorgang mit bereits aufgesetztem elektronischen Bauteil 20. Im Unterschied zur Darstellung gemäß den Figuren 1A und 1B ist in den Figuren 2A und 2B an der Außenseite 11 der Leiterplatte 10 jeweils eine Kunststofffolie 30 mit einer Foliendicke 31 und mit Ausnehmungen 32 befestigt. Die Kunststofffolie 30 ist hier jeweils mit einer Klebstoffschicht 40 an der Außenseite 11 angeklebt. Damit liegt die Kunststofffolie 30 plan auf der Außenseite 11 der Leiterplatte 10 an und dient als Abstandhalter für die zu bestückenden elektronischen Bauteile 20. Die Ausnehmungen 32 sind so in der Kunststofffolie 30 positioniert, dass diese einerseits exakt den Setzpositionen der Kontaktpads 25 des jeweiligen Bauteils 20 entsprechen und andererseits denjenigen Leiterbahnabschnitt 12 der Leiterplatte 10 freistellen, der einem bestimmten Kontaktpad 25 zugeordnet ist. Die Ausnehmungen 32 mit ihrer Foliendicke 31 wirken als nach oben offene Behältnisse zur Aufnahme von Leitkleber 50, der je nach Geometrie der Kontaktpads mit einer Füllhöhe 51 des Leitklebers 50 bis zur Foliendicke 31 oder auch geringfügig darüber in die Ausnehmungen 32 eingefüllt wird. Vorteilhaft kann die genau erforderliche Menge an Leitkleber 50 mittels eines Dispensers in die Ausnehmungen gefüllt werden. Dies ist in Fig. 2A veranschaulicht.

Beim anschließenden Bestücken mit einem automatischen Bestücker wird das Bauteil 20 mit einer Bestückungskraft 100 auf die entsprechende Setzposition 29 auf die Leiterplatte 11 gedrückt. Vorteilhaft dient nun die Kunststofffolie 30 als Abstandhalter und das Bauteil 20 liegt an seiner Unterseite 21 zumindest abschnittsweise auf der Kunststofffolie 30 auf. Die Kontaktpads 25 des Bauteils 20 können beim Bestücken nicht beschädigt werden, da diese im Bereich der Ausnehmungen 32 in das bereits vorbereitete Leitkleberdepot treffen. Aufgrund der gewählten Foliendicke 31 der Kunststofffolie 30, die beispielsweise von 50 µm bis 150 µm vorgewählt werden kann und erforderlichenfalls auch mit einer noch größeren Foliendicke über 150 µm eingesetzt werden kann, kann beim Bestücken der Leitkleber 50 auch nicht seitlich aus den Ausnehmungen 32 herausgedrückt werden. Vorteilhaft werden somit mit dem erfindungsgemäßen Einsatz von Kunststofffolie 30 als Abstandhalter nicht nur Kurzschlüsse unterhalb der oberflächenmontierten elektronischen Bauteile 20 verhindert, sondern es können so auch empfindliche Bauteile 20 mit automatischen Bestückern montiert werden, ohne dass es dabei zu mechanischen Beschädigungen der Bauteile 20, ihrer Kontaktpads 25 und/oder der darunterliegenden Leiterbahnabschnitte 12 auf der Leiterplatte 10 kommt.

In Fig. 2B ist am fertig montierten Bauteil 20 zu erkennen, dass dieses an seiner Unterseite 21 auf der Kunststofffolie 30 aufliegt. Im gehärteten Zustand stellt sich innerhalb der Ausnehmungen 32 eine Klebespaltdicke 55 ein, die im Wesentlichen der Foliendicke 31 der Kunststofffolie 30 abzüglich der Höhe 26 der jeweiligen Kontaktpads 26 an der Unterseite 21 des Bauteils 20 entspricht.

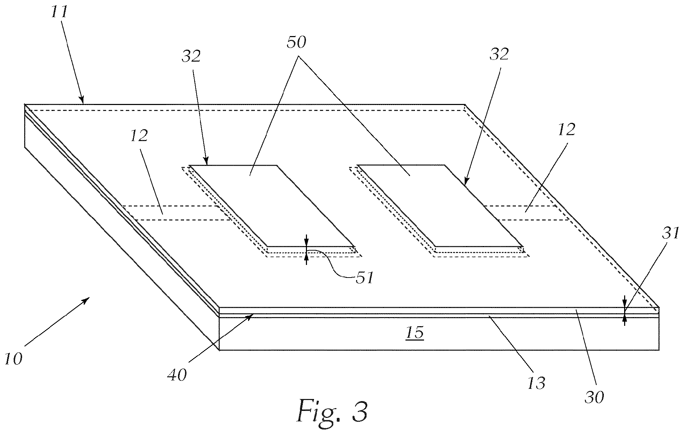

**Fig. 3** zeigt schräg von oben ein Detail der in Fig. 2A dargestellten Leiterplatte 10 mit einer an ihrer Außenseite befestigten Kunststofffolie 30 direkt vor dem Bestücken mit einem hier der besseren Übersichtlichkeit halber nicht gezeigten elektronischen Bauteil. Die beiden Ausnehmungen 32 in der Kunststofffolie 30 sind hier entsprechend ihrer Foliendicke 31 mit Leitkleber 50 befüllt. Die Füllhöhe 51 des Leitklebers 50 entspricht hier somit im Wesentlichen der Foliendicke 31. Diese Kontaktstellen sind somit für das Bestücken mit einem BTC-Bauteil (bottom termination component) vorbereitet, bei dem die Kontaktpads an der Unterseite des Bauteils im Wesentlichen plan mit der Unterseite sind. Beim Bestücken liegt das BTC-Bauteil dann vorteilhaft an seiner Unterseite zumindest zwischen den beiden mit Leitkleber 50 befüllten Ausnehmungen 32 auf der Kunststofffolie 30 auf. Diese dient als Abstandhalter, weshalb ein seitliches Herausquetschen des Leitklebers 50 aus den Ausnehmungen 32 zuverlässig verhindert werden kann.

### LISTE DER BEZUGSZEICHEN

- 10: Leiterplatte
- 11: Außenseite der Leiterplatte
- 12: Leiterbahn
- 13: Isolationsschicht
- 15: Substrat
- 20: elektronisches Bauteil
- 21: Unterseite des elektronischen Bauteils
- 25: Kontaktpad des elektronischen Bauteils
- 26: Höhe des Kontaktpads an der Unterseite des Bauteils
- 29: Setzposition des elektronischen Bauteils bzw. einzelner Kontaktpads
- 30: Kunststofffolie
- 31: Foliendicke der Kunststofffolie
- 32: Ausnehmung in der Kunststofffolie
- 40: Klebstoffschicht
- 50: Leitkleber
- 51: Füllhöhe des Leitklebers
- 55: Klebespaltdicke
- 100: Bestückungskraft (Pfeil)

## Patentansprüche

1. Leiterplatte (10) mit zumindest einem an einer Außenseite (11) der Leiterplatte (10) montierten elektronischen Bauteil (20), **dadurch gekennzeichnet, dass** zwischen dem zumindest einen elektronischen Bauteil (20) und der dem Bauteil (20) zugeordneten Außenseite (11) der Leiterplatte (10) eine Kunststofffolie (30) mit einer Foliendicke (31) sowie mit mehreren Ausnehmungen (32) angeordnet ist, wobei die Kunststofffolie (30) an der Außenseite (11) der Leiterplatte (10) befestigt ist und wobei die Ausnehmungen (32) in der Kunststofffolie (30) mit Leitkleber (50) zumindest teilweise befüllt sind und diese Ausnehmungen (32) an der Setzposition (29) des Bauteils (x) so positioniert sind, dass mit dem Leitkleber (50) innerhalb einer Ausnehmung (32) ein Leiterbahnabschnitt (12) an der Außenseite (11) der Leiterplatte (10) mit einem Kontaktpad (25) an der Unterseite (21) des zumindest einen Bauteils (20) leitend verbunden ist.

2. Leiterplatte (10) nach Anspruch 1, **dadurch gekennzeichnet, dass** das zumindest eine elektronische Bauteil (20) zumindest abschnittsweise mit seiner Unterseite (21) auf der Außenseite (11) der Kunststofffolie (30) aufliegt.

3. Leiterplatte (10) nach Anspruch 1 oder 2, **dadurch gekennzeichnet, dass** eine Füllhöhe (51) des Leitklebers (50) innerhalb der Ausnehmungen (32) der Kunststofffolie (30) kleiner oder gleich der Foliendicke (31) der Kunststofffolie (30) ist.

4. Leiterplatte (10) nach einem der Ansprüche 1 bis 3, **dadurch gekennzeichnet, dass** jedem Kontaktpad (25) des zumindest einen elektronischen Bauteils (20) eine Ausnehmung (32) in der Kunststofffolie (30) zugeordnet ist.

5. Leiterplatte (10) nach einem der Ansprüche 1 bis 4, **dadurch gekennzeichnet, dass** die Kunststofffolie (30) an der Außenseite (11) der Leiterplatte (10) zumindest abschnittsweise mit einer Klebstoffschicht (40) angeklebt ist.

6. Leiterplatte (10) nach einem der Ansprüche 1 bis 5, **dadurch gekennzeichnet, dass** die Kunststofffolie (30) eine Erweichungstemperatur hat, die kleiner als die Härtungstemperatur des Leitklebers (50) ist.

7. Leiterplatte (10) nach Anspruch 6, **dadurch gekennzeichnet, dass** die Kunststofffolie (30) eine Erweichungstemperatur von 90° bis 120°C und der Leitkleber (50) eine Härtungstemperatur von 100° bis 150°C aufweist.

8. Leiterplatte (10) nach einem der Ansprüche 1 bis 5, **dadurch gekennzeichnet, dass** die Kunststofffolie (30) eine Erweichungstemperatur hat, die größer als die Härtungstemperatur des Leitklebers (50) ist.

9. Leiterplatte (10) nach Anspruch 8, **dadurch gekennzeichnet, dass** die Kunststofffolie (30) eine Erweichungstemperatur von 140° bis 160°C und der Leitkleber (50) eine Härtungstemperatur von 100° bis 150°C aufweist.

10. Verfahren zur Herstellung einer Leiterplatte (10) mit zumindest einem an einer Außenseite (11) der Leiterplatte (10) montierten elektronischen Bauteil (20) nach einem der Ansprüche 1 bis 9, **gekennzeichnet durch** eine Abfolge der folgenden Schritte:
- a- Bereitstellen einer Leiterplatte (10) mit Leiterbahnen (12) zur außenseitigen Montage zumindest eines elektronischen Bauteiles (20);
- b- Bereitstellen einer Kunststofffolie (30) mit einer Foliendicke (31), wobei die Kunststofffolie (30) zumindest abschnittsweise an einer Außenseite (11) der Leiterplatte (10) im Bereich des zu bestückenden elektronischen Bauteiles (20) befestigbar ist;
- c- Herstellen von Ausnehmungen (32) in der Kunststofffolie (30), wobei die Position der Ausnehmungen (32) der Lage der Kontaktpads (25) des zu bestückenden elektronischen Bauteiles (20) in seiner Setzposition (29) entsprechen und die Ausnehmungen (32) jeweils komplementär sind mit einem Abschnitt einer Leiterbahn (12) an der Außenseite (11) der Leiterplatte (10);
- d- Befestigen der Kunststofffolie (30) an derjenigen Außenseite (11) der Leiterplatte (10), welche dem für die außenseitige Montage vorgesehenen zumindest einen elektronischen Bauteil (20) zugeordnet ist, wobei die Ausnehmungen (32) in der Kunststofffolie (30) anhand der Setzpositionen (29) der Kontaktpads (25) des Bauteils (20) sowie des Verlaufs der Leiterbahnen (12) ausgerichtet werden;
- e- Aufbringen von Leitkleber (50) in den Ausnehmungen (32) der befestigten Kunststofffolie (30), wobei die Füllhöhe (51) des Leitklebers (50) innerhalb der Ausnehmungen (32) kleiner oder gleich der Foliendicke (31) gewählt wird;
- f- Bestücken eines elektronischen Bauteils (20), wobei das Bauteil (20) mit seiner Unterseite (21) in seiner Setzposition (29) so auf der Kunststofffolie (30) aufgedrückt (100) wird, dass die Kontaktpads (25) des Bauteils (20) im Bereich der Ausnehmungen (32) zu liegen kommen und mit dem Leitkleber (50) kontaktiert werden, wobei das Bauteil (20) an seiner Unterseite (21) zumindest abschnittsweise auf der Kunststofffolie (30) aufliegt.

11. Verfahren zur Herstellung einer Leiterplatte (10) nach Anspruch 10, **dadurch gekennzeichnet, dass** in Schritt -d- die Kunststofffolie (30) mit einer Klebstoffschicht (40) zumindest abschnittsweise an einer Außenseite (11) der Leiterplatte (10) angeklebt wird.

12. Verfahren zur Herstellung einer Leiterplatte (10) nach Anspruch 10 oder 11, **dadurch gekennzeichnet, dass** in Schritt -e- der Leitkleber (50) mit einem Dispenser in die Ausnehmungen (32) der Kunststofffolie (30) eingebracht wird.

13. Verfahren zur Herstellung einer Leiterplatte (10) nach Anspruch 10 oder 11, **dadurch gekennzeichnet, dass** in Schritt -e- der Leitkleber (50) durch einen Schablonendruckprozess in die Ausnehmungen (32) der Kunststofffolie (30) eingebracht wird, wobei die Ausnehmungen (32) der Kunststofffolie (30) als Schablonen dienen.

14. Verfahren zur Herstellung einer Leiterplatte (10) nach einem der Ansprüche 10 bis 13, **dadurch gekennzeichnet, dass** in Schritt -b- eine Kunststofffolie (30) mit einer Erweichungstemperatur bereitgestellt wird, die kleiner als die Härtungstemperatur des Leitklebers (50) ist, wobei nach dem Bestücken (Schritt -f-) in einem anschließenden Wärmebehandlungsschritt -g- die bestückte Leiterplatte (10) bis zur Härtungstemperatur des Leitklebers (50) erwärmt wird, wobei nach Überschreiten der Erweichungstemperatur der Kunststofffolie (30) gegebenenfalls die Setzposition des elektronischen Bauteils (29) mechanisch ausgerichtet wird.

15. Verfahren zur Herstellung einer Leiterplatte (10) nach einem der Ansprüche 10 bis 13, **dadurch gekennzeichnet, dass** in Schritt -b- eine Kunststofffolie (30) mit einer Erweichungstemperatur bereitgestellt wird, die größer als die Härtungstemperatur des Leitklebers (50) ist, wobei nach dem Bestücken (Schritt -f-) in einem anschließenden Wärmebehandlungsschritt -g'- die bestückte Leiterplatte (10) zuerst bis zur Härtungstemperatur des Leitklebers (50) erwärmt wird, und nach dem Aushärten des Leitklebers (50) die bestückte Leiterplatte (10) anschließend bis zur Erweichungstemperatur der Kunststofffolie (30), gegebenenfalls bis zur Schmelztemperatur der Kunststofffolie (30), erhitzt wird.
